# EUROPÄISCHE PATENTSCHRIFT

(11) **EP 3 293 498 B1**
(45) Veröffentlichungstag und Bekanntmachung des Hinweises auf die Patenterteilung: **21.11.2018**
(21) Anmeldenummer: 17187237.7
(22) Anmeldetag: 22.08.2017
(51) Int. Cl.: G01D 21/00

(54) **SIGNALVERARBEITUNGSEINHEIT**
SIGNAL PROCESSING UNIT
UNITÉ DE TRAITEMENT DE SIGNAL

(30) Priorität: 07.09.2016 DE 102016116733
(43) Veröffentlichungstag der Anmeldung: 14.03.2018
(73) Patentinhaber: Sick AG, 79183 Waldkirch (DE)
(72) Erfinder: Brodd, Dieter, 79241 Ihringen (DE); Dwivedi, Shivam, 79110 Freiburg (DE); Staudinger, Gunther, 79106 Freiburg (DE)

(56) Entgegenhaltungen:
- EP-A1- 3 002 615
- US-A1- 2016 231 346

## Beschreibung

Die vorliegende Erfindung betrifft ein System gemäß dem Oberbegriff von Anspruch 1 und ein Verfahren gemäß dem Oberbegriff von Anspruch 6.

Die vorliegende Erfindung betrifft Sensoren, die in sicheren Anwendungen verwendet werden. Wenn Sensoren räumlich getrennt sind und auch eine getrennte Verkabelung verwendet wird, können Fehler wie Kurzschlüsse zwischen den Kabeln ausgeschlossen werden. Werden diese Sensoren in einem Verdrahtungsknoten zusammengefasst und laufen die Sensorinformationen über einen gemeinsamen Stecker oder ein gemeinsames Kabel, so müssen Querschlüsse angenommen werden, welche zu einem sicherheitskritischen Fehlverhalten des Systems führen können. Deshalb müssen Querschlüsse zwischen Signalleitern von Sensoren erkannt werden. Diese Erkennung funktioniert nur, wenn sich die Sensorsignale auf den Signalleitern unterscheiden.

Die DE 10 2012 205 289 A1 offenbart ein Verfahren zum Betreiben eines Sicherheitssensors, der einen Schaltausgang und einen Diagnoseausgang aufweist, wobei der Schaltausgang ein Schaltfreigabesignal und der Diagnoseausgang ein Diagnosefreigabesignal ausgibt. Der Diagnoseausgang wird gegenüber dem Schaltausgang verzögert angesteuert, um während dieses Zeitraums eine Querschlusserkennung durchführen zu können.

Die EP 3 002 615 A1 offenbart eine Sensorvorrichtung, gemäß der ein Werkstück, welches befördert wird, geeignet erfasst werden kann, ohne dass eine komplexe Einstellaufgabe erforderlich ist, unabhängig von der Form des Werkstück oder unabhängig dem Vorhandensein von Vibrationen. Eine Sensorvorrichtung umfasst mehrere Paare, die jeweils ein Licht emittierendes Element und ein Licht empfangendes Element aufweisen. In einem Anfangszustand wird das Abtasten unter Verwendung einer optischen Abtastachse durchführt, die aus einem Teil der optischen Achsen besteht. Wenn beim Abtasten im Ausgangszustand blockiert wird, wird die Anzahl der optischen Achsen, die in der optischen Erfassungsachse enthalten sind, erhöht, um die optische Erfassungsachsen zu erweitern.

Eine Aufgabe der Erfindung besteht darin, Sensorsignale, die in einem gemeinsamen Kabel geführt sind, auf Querschlüsse hin zu überprüfen.

Die Aufgabe wird gemäß Anspruch 1 gelöst.

Die Aufgabe wird weiter gemäß Anspruch 6 gelöst.

Gemäß der Erfindung handelt es sich bei den Sensoren um unabhängige Signalquellen, die unterschiedliche Ereignisse detektieren. Dennoch kann es vorkommen, dass diese unabhängigen Ereignisse gleichzeitig auftreten und dann zu jeweils einem gleichzeitigen Sensorsignal der Sensoren führen.

Die der Signalverarbeitungseinheit nachgeordnete Verarbeitungseinheit überprüft die Sensorsignale der Sensoren auf Querschlüsse. Dabei wird überprüft, ob die Sensorsignale jeweils unterschiedliche Signalpegel aufweisen, wodurch ein Querschluss ausgeschlossen werden kann, bei dem beide Sensorsignale zwingend einen gleichen Pegel aufweisen würden. Ein Querschlusstest ist möglich, wenn die Sensorsignale unterschiedliche Pegel haben. Prinzipbedingt ist dies der Fall, wenn einer der beiden Sensoren geschaltet hat und der andere noch nicht.

Gemäß der Erfindung werden somit zwei unabhängige, getrennte und damit zunächst querschlussfreie Sensorsignale derart modifiziert, dass diese immer zeitlich unterschiedliche Pegel aufweisen, also zeitlich unterschiedlich schalten und dann zur Weiterleitung an die Verarbeitungseinheit nicht mehr räumlich getrennt werden müssen, sondern auf unterschiedlichen Signalleitern einem gemeinsamen Kabel geführt werden können.

Gemäß der Erfindung ist die Steuer- und Auswerteeinheit ausgebildet, eine Signaländerung bei einem ersten bzw. vorhergehenden Sensorsignal eines Sensors zu erzeugen bei einer Flanke eines nachfolgenden Sensorsignals eines anderen Sensors, wobei die Signaländerung eine vorgegebene Zeitdauer aufrechterhalten wird. Die Bezeichnung erstes Sensorsignal und zweites Sensorsignal bezieht sich dabei lediglich auf die Bezeichnung des Sensorsignals und nicht auf dessen zeitliche Reihenfolge.

Signalleiter können auch als Signaladern bezeichnet werden. Eine Signalader bezeichnet dabei auch einen isolierten Signalleiter. Signalleiter oder Signaladern können in einem gemeinsamen Kabel oder einer gemeinsamen Leitung geführt sein.

Die Signalverarbeitungseinheit ist optional in einem Gehäuse angeordnet, wobei in dem Gehäuse die Steuer- und Auswerteeinheit angeordnet ist.

Gemäß der Erfindung sind die Eingangsanschlüsse jeweils mit einem optoelektronischen Sensor verbunden, wobei die optoelektronischen Sensoren jeweils zur Detektion von Material an einer Mutingstation angeordnet sind und die Verarbeitungseinheit am Ausgangsanschluss eine Mutingauswerteeinheit ist, um ein Objektfeststellungssignal zu überbrücken.

Eine Mutingstation weist beispielsweise eine Sicherheitsanordnung mit einem Lichtgitter und mit beispielsweise zwei optoelektronischen Sensoren als Muting-Sensoren auf, die beispielsweise gekreuzt an einem Förderband angeordnet sind. Auf dem Förderband werden Objekte, beispielsweise beladene Paletten zu einer verarbeitenden Einrichtung, beispielsweise zu einer Verpackungsmaschine transportiert. Bei den Muting-Sensoren handelt es sich beispielsweise um Lichtschranken, deren Lichtstrahl über einen Reflektor zur Lichtschranke reflektiert wird und dort ein Erkennungssignal auslöst. Durch einen Durchgang sollen lediglich zulässige Objekte, nämlich die Paletten, zu der Verpackungsmaschine gelangen. Personen jedoch soll der Zugang zu der Verpackungsmaschine nicht ermöglicht werden. Um den Zugang für Personen zu verhindern, ist im Bereich der Kreuzungspunkte der Lichtstrahlen der Lichtschranken im Bereich des Durchgangs das Lichtgitter angeordnet. Wird ein durch das Lichtgitter erzeugtes Schutzfeld durch eine eintretende Person verletzt, wird ein Warn- oder Steuersignal ausgegeben, um das Förderband unverzüglich anzuhalten und eine gefahrbringende Bewegung der Verpackungsmaschine abzuschalten oder die Maschine in einen gefahrlosen Zustand zu bringen.

Ein solches Verfahren ist unter dem Begriff 'Muting' bekannt und bezeichnet dabei die Überbrückung der Schutzwirkung des Lichtgitters für eine bestimmte Dauer, damit Material, beispielsweise die Palette, zu einer Maschine oder Anlage befördert werden kann, ohne dass ein Arbeitsprozess unterbrochen werden muss. Beim Muting wird mit Hilfe der Mutingsensoren mit zusätzlichen Sensorsignalen zwischen Personen und Objekten unterschieden. Die Verarbeitungseinheit wertet dazu die Sensorsignale von den Mutingsensoren logisch aus und überbrückt bei einer gültigen Mutingbedingung das Lichtgitter, so dass das zu transportierende Objekt die Schutzeinrichtung, also das Lichtgitter passieren kann. Sobald etwas anderes als das Objekt in den Gefahrenbereich eindringt, wird der Arbeitsprozess unterbrochen.

Das Objekt bewegt sich auf dem Förderband zunächst auf die Mutingsensoren zu. Sobald die Mutingsensoren betätigt sind, wird die Schutzwirkung des Lichtgitters überbrückt und das Objekt kann das Lichtgitter passieren und in einen Gefahrenbereich hineinfahren. Sobald das Objekt die Mutingsensoren passiert hat und deren Lichtstrahl nicht mehr unterbrochen ist, wird die Schutzwirkung des Lichtgitters wieder aktiviert.

In Weiterbildung der Erfindung ist die Signaländerung eine Pegeländerung. Beispielsweise handelt es sich bei der Pegeländerung um ein Spannungssignal, welches seinen Pegel von beispielsweise 0 Volt auf 24 Volt ändert oder umgekehrt von 24 Volt auf 0 Volt. Jedoch können auch andere Pegel vorgesehen sein.

In Weiterbildung der Erfindung ist die Signaländerung mindestens eine Signaltestlücke, wobei die Testlücke eine Länge von ca. 1 ms bis ca. 50 ms, insbesondere ca. 10 ms beträgt. Die Testlücke ist eine Pegeländerung für eine kurze Zeit, die sich jedoch schalttechnisch auf einen nachfolgenden Aktor oder einen nachfolgenden Signaleingang der Verarbeitungseinheit auswirkt. Die Signaltestlücke führt jedoch dazu dass die Sensorsignale des ersten Sensors und des zweiten Sensors unterschiedlich sind, um einen möglichen Querschluss zu erkennen. Die Signaltestlücken können auch eine unterschiedliche Dauer aufweisen.

In Weiterbildung der Erfindung ist die Signaländerung eine Signalmodulation. Dabei können die Sensorsignale z. B. unterschiedliche Spannungspegel aufweisen oder es wird eine Amplitudenmodulation mindestens eines Sensorsignales durchgeführt oder eine andere unterscheidbare Information aufmoduliert.

In Weiterbildung der Erfindung sind mehr als zwei Sensoren angeschlossen, wobei die Steuer- und Auswerteeinheit ausgebildet ist, eine Signaländerung bei einem Sensorsignal eines Sensors zu erzeugen bei einer Flanke oder Signaländerung eines Sensorsignals eines anderen Sensors, wobei die Signaländerung eine vorgegebene Zeitdauer aufrechterhalten ist. Dadurch können die Sensorsignale von einer Mehrzahl oder Vielzahl von Sensoren über jeweils eine Mehrzahl von Signalleitern in einem gemeinsamen Kabel geführt werden.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Figur 1: eine erfindungsgemäße Signalverarbeitungseinheit;
- Figur 2: eine Mutingstation;
- Figuren 3 bis 6: jeweils Zeitdiagramme zu Sensorsignalen.

In den nachfolgenden Figuren sind identische Teile mit identischen Bezugszeichen versehen.

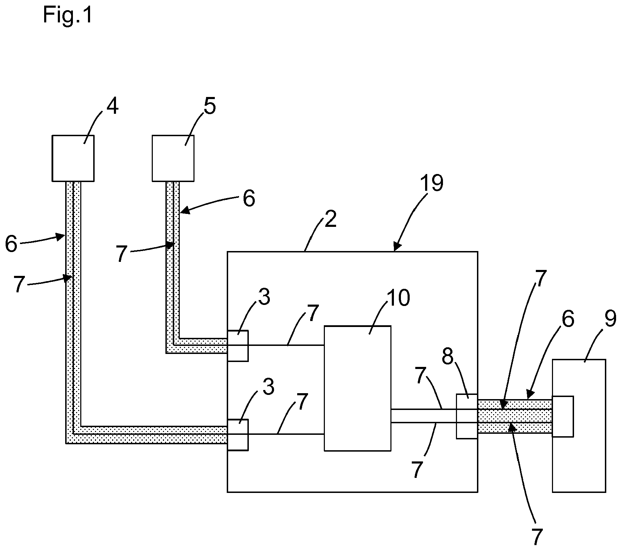

Figur 1 zeigt eine Signalverarbeitungseinheit 19 mit einem Gehäuse 2 mit mindestens zwei getrennten Eingangsanschlüssen 3 für jeweils einen Sensor 4 und 5 mit jeweils einem Kabel 6 mit jeweils mindestens einem Signalleiter 7 für jeden Sensor 4 und 5 und mindestens einem Ausgangsanschluss 8 zum Übertragen der Sensorsignale an eine Verarbeitungseinheit 9 mittels eines Kabels 6 mit mindestens zwei Signalleitern 7, wobei in dem Gehäuse 2 eine Steuer- und Auswerteeinheit 10 angeordnet ist, wobei die Steuer- und Auswerteeinheit 10 ausgebildet ist, eine Signaländerung bei einem ersten Sensorsignal des ersten Sensors 4 zu erzeugen bei einer Flanke eines zweiten Sensorsignals des zweiten Sensors 5, wobei die Signaländerung des ersten Sensorsignals eine vorgegebene Zeitdauer aufrechterhalten ist, wobei die Steuer- und Auswerteeinheit 10 ausgebildet ist, das erste geänderte Sensorsignal und das zweite Sensorsignal jeweils auf den Signalleitern 7 des Ausgangsanschlusses 8 auszugeben.

Die der Signalverarbeitungseinheit 19 nachgeordnete Verarbeitungseinheit 9 überprüft die Sensorsignale der Sensoren 4 und 5 auf Querschlüsse. Dabei wird überprüft, ob die Sensorsignale jeweils unterschiedliche Signalpegel aufweisen, wodurch ein Querschluss ausgeschlossen werden kann, bei dem beide Signale zwingend einen gleichen Pegel aufweisen würden. Die Querschlusserkennung wird in der Verarbeitungseinheit 9 durchgeführt. Jedoch kann optional auch eine Querschlusserkennung in der Signalverarbeitungseinheit 19 ausgangsseitig durchgeführt werden.

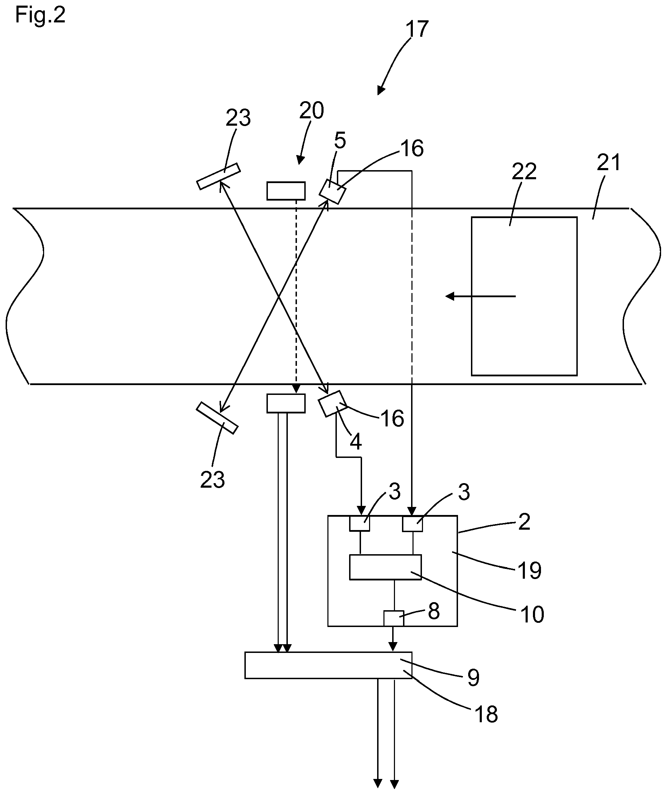

Gemäß Figur 2 sind die Eingangsanschlüsse 3 jeweils mit einem optoelektronischen Sensor 16 verbunden, wobei die optoelektronischen Sensoren 16 jeweils zur Detektion von Material an einer Mutingstation 17 angeordnet sind und die Verarbeitungseinheit 9 am Ausgangsanschluss 8 eine Mutingauswerteeinheit 18 ist, um ein Objektfeststellungssignal zu überbrücken.

Eine Mutingstation 17 weist beispielsweise eine Sicherheitsanordnung mit einem Lichtgitter 20 und mit beispielsweise zwei optoelektronischen Sensoren 16 als Muting-Sensoren auf, die beispielsweis gekreuzt an einem Förderband 21 angeordnet sind. Auf dem Förderband 21 werden Objekte 22, beispielsweise beladene Paletten, zu einer verarbeitenden Einrichtung, beispielsweise zu einer Verpackungsmaschine transportiert. Bei den Mutingsensoren handelt es sich beispielsweise um Lichtschranken, deren Lichtstrahl über einen Reflektor 23 zur Lichtschranke reflektiert wird und dort ein Erkennungssignal auslöst. Durch einen Durchgang sollen lediglich zulässige Objekte 22, nämlich die Paletten, zu der Verpackungsmaschine gelangen. Personen jedoch soll der Zugang zu der Verpackungsmaschine nicht ermöglicht werden. Um den Zugang für Personen zu verhindern, ist im Bereich des Kreuzungspunktes der Lichtstrahlen der Lichtschranken im Bereich des Durchgangs das Lichtgitter 20 angeordnet. Wird ein durch das Lichtgitter 20 erzeugtes Schutzfeld durch eine eintretende Person verletzt, wird ein Warn- oder Steuersignal ausgegeben, um das Förderband 21 unverzüglich anzuhalten und eine gefahrbringende Bewegung der Verpackungsmaschine abzuschalten oder die Maschine in einen gefahrlosen Zustand zu bringen.

Die Verarbeitungseinheit 9 wertet dazu die Sensorsignale von den Mutingsensoren logisch aus und überbrückt bei einer gültigen Mutingbedingung das Lichtgitter 20, so dass das zu transportierende Objekt 22 die Schutzeinrichtung, also das Lichtgitter 20 passieren kann. Sobald etwas anderes oder jemand anderes als das Objekt 22 in den Gefahrenbereich eindringt, wird der Arbeitsprozess unterbrochen.

Das Objekt 22 bewegt sich auf dem Förderband 21 zunächst auf die Mutingsensoren zu. Sobald die Mutingsensoren betätigt sind, wird die Schutzwirkung des Lichtgitters 20 überbrückt und das Objekt 22 kann das Lichtgitter 20 passieren und in einen Gefahrenbereich hineinfahren. Sobald das Objekt 22 die Mutingsensoren passiert hat und deren Lichtstrahl nicht mehr unterbrochen ist, wird die Schutzwirkung des Lichtgitters 20 wieder aktiviert. Die gekreuzten Lichtstrahlen der Sensoren 16 werden mit hoher Wahrscheinlichkeit gleichzeitig oder nahezu gleichzeitig durch das Objekt 22 ausgelöst.

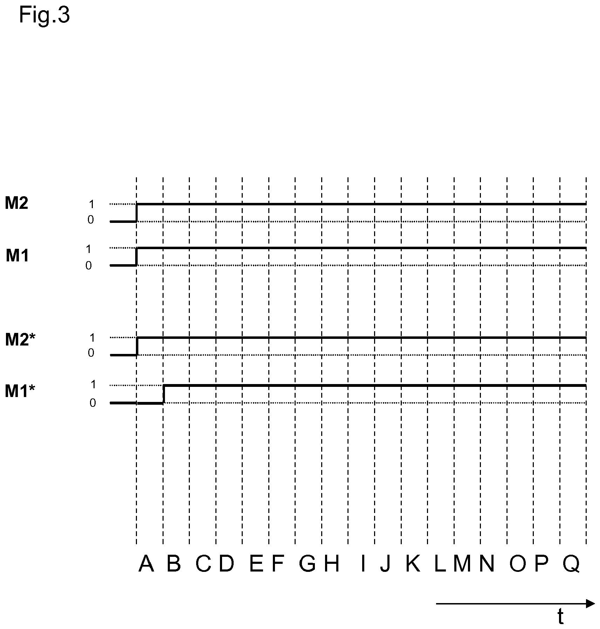

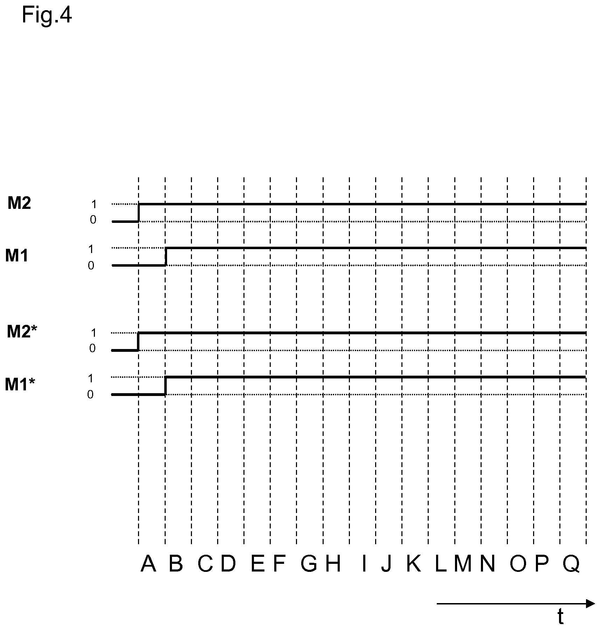

Gemäß Figur 3 ist die Signaländerung eine Pegeländerung. Die Pegel sind gemäß Figur 4 beispielsweise durch die logischen Pegel 0 und 1 dargestellt.

Beispielsweise handelt es sich bei der Pegeländerung um ein Spannungssignal, welches seinen Pegel von beispielsweise 0 Volt auf 24 Volt ändert oder umgekehrt von 24 Volt auf 0 Volt. Jedoch können auch andere Pegel vorgesehen sein.

Gemäß Figur 3 ändern die Sensorsignale M1 und M2 gleichzeitig ihren Pegel von 0 auf 1. Die Sensorsignale sind entlang einer Zeitachse mit der Zeit t aufgetragen. Dabei wird von der Steuer- und Auswerteeinheit zunächst ein erstes Sensorsignal M1 und ein zweites Sensorsignal M2 erfasst. Danach wird das erste Sensorsignal M1* quasi verzögert, also dessen Pegel von 1 nach 0 für eine bestimmte Zeitdauer, bzw. eine bestimmte detektierbare Zeitdauer geändert, wobei danach der vorliegende Pegel wieder eingenommen wird, gemäß dem Zeitpunkt B des geänderten Sensorsignals M1*. Das Sensorsignal M2 wird als Sensorsignal M2* unverändert ausgegeben.

Gemäß Figur 4 sind die Sensorsignale M1 und M2 bereits zeitverzögert. In diesem Fall wird das erste Sensorsignal M1 nicht geändert bzw. verzögert, da die jeweiligen Flanken bzw. Pegeländerungen bereits zu unterschiedlichen Zeitpunkten erfolgen. Die Sensorsignale M1 und M2 werden als Sensorsignale M1* und M2* unverändert ausgegeben.

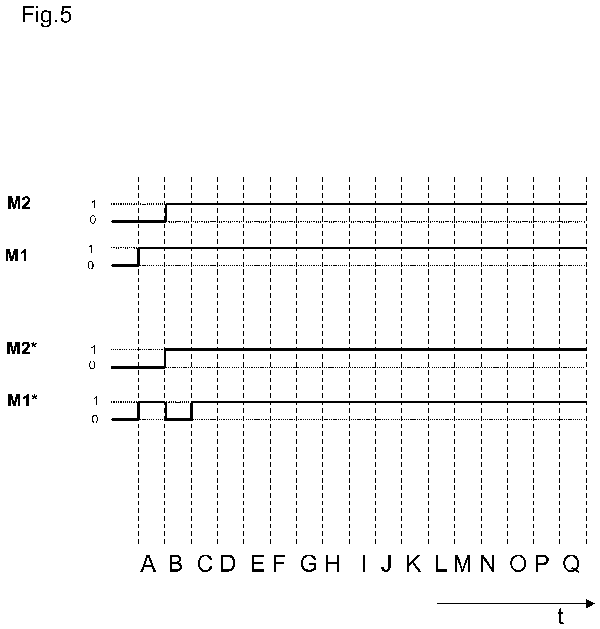

Gemäß Figur 5 ist die Signaländerung bzw. die Flanke des ersten Sensorsignals M1 früher als die Signaländerung bzw. Flanke des zweiten Sensorsignals M2. Zwar könnten die Sensorsignale gemäß Figur 5 unverändert auf Querschlüsse hin überprüft werden. Jedoch ist es auch vorgesehen in diesem Fall eine Änderung des ersten Sensorsignals M1 vorzunehmen, um beispielsweise eine Detektionssicherheit zu erhöhen und/oder die Steuer- und Auswerteeinheit einfacher auszubilden, da dann keine Fallunterscheidung durch die Steuer- und Auswerteeinheit durchgeführt werden muss, sondern immer eine Signalverzögerung bzw. eine Signaländerung durchgeführt wird, gemäß Zeitpunkt B, Sensorsignal M1* von Figur 5, auch wenn die Zeitpunkte der Signaländerung auch bereits bei den ursprünglichen Sensorsignalen M1 und M2 vorliegen. Die Sensorsignale M1 und M2 werden als Sensorsignale M1* und M2* ausgegeben.

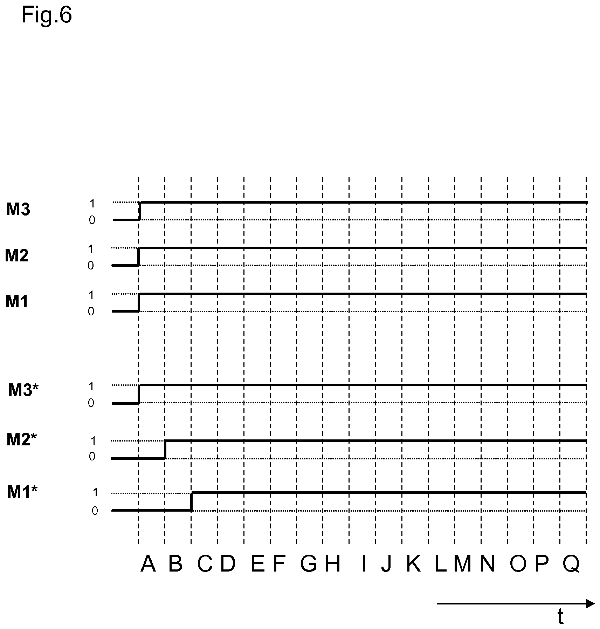

Gemäß Figur 6 sind mehr als zwei Sensoren, nämlich beispielhaft drei Sensoren angeschlossen, wobei die Steuer- und Auswerteeinheit ausgebildet ist, eine Signaländerung bei einem Sensorsignal M1, M2 eines Sensors zu erzeugen bei einer Flanke eines nachfolgenden Sensorsignals M2, M3 eines anderen Sensors, wobei die Signaländerung eine vorgegebene Zeitdauer aufrechterhalten ist. Auch für mehr als zwei Sensoren gelten die obigen Feststellungen gemäß den vorhergehenden Figuren zu zwei Sensorsignalen bzw. zwei Sensoren. Bei mehr als zwei Sensorsignalen wird für jedes weitere Signal eine zusätzliche Signaländerung bzw. Verzögerungszeit eingeführt.

Beispielsweise wird aufgrund des Sensorsignals M2 das Sensorsignal M1* verzögert bzw. mit einem zeitlich begrenzten Signalwechsel versehen. Und beispielsweise werden aufgrund des Sensorsignals M3 die Sensorsignale M2* und M1* verzögert. Die Sensorsignale M1, M2 und M3 werden als Sensorsignale M1*, M2* und M3* ausgegeben.

### Bezugszeichen:

- 0: Pegel
- 1: Pegel
- 2: Gehäuse
- 3: Eingangsanschluss
- 4: erster Sensor
- 5: zweiter Sensor
- 6: Kabel
- 7: Signalleiter
- 8: Ausgangsanschluss
- 9: Verarbeitungseinheit
- 10: Steuer- und Auswerteeinheit
- M1, M1*: erstes Sensorsignal
- M2, M2*: zweites Sensorsignal
- M3, M3*: drittes Sensorsignal
- 16: optoelektronischer Sensor
- 17: Mutingstation
- 18: Mutingauswerteeinheit
- 19: Signalverarbeitungseinheit
- 20: Lichtgitter
- 21: Förderband
- 22: Objekt
- 23: Reflektor
- A bis Q: Zeitpunkte
- t: Zeit

## Patentansprüche

1. System, umfassend eine Verarbeitungseinheit (9), zwei Sensoren (4, 5, 16) und eine Signalverarbeitungseinheit (19) mit mindestens zwei getrennten Eingangsanschlüssen (3) für jeweils einen der Sensoren (4, 5, 16) mit jeweils einem Kabel (6) mit jeweils mindestens einem Signalleiter (7) für jeden Sensor (4, 5, 16) und mindestens einem Ausgangsanschluss (8) zum Übertragen der Sensorsignale (M) an eine Verarbeitungseinheit (9) mittels eines Kabels (6) mit mindestens zwei Signalleitern (7),
**dadurch gekennzeichnet, dass**
die Signalverarbeitungseinheit (19) eine Steuer- und Auswerteeinheit (10) umfasst, wobei die Steuer- und Auswerteeinheit (10) ausgebildet ist, eine Signaländerung bei einem ersten Sensorsignal (M1) des ersten Sensors (4) zu erzeugen bei einer Flanke oder Signaländerung eines zweiten Sensorsignals (M2) des zweiten Sensors (5), wobei die Signaländerung des ersten Sensorsignals eine vorgegebene Zeitdauer aufrechterhalten ist,
wobei die Steuer- und Auswerteeinheit (10) ausgebildet ist, das erste geänderte Sensorsignal (M1*) und das zweite Sensorsignal (M2*) jeweils auf den Signalleitern (7) des Ausgangsanschlusses (8) auszugeben, wobei eine Querschlusserkennung in der Verarbeitungseinheit (9) oder in der Signalverarbeitungseinheit (19) ausgangsseitig durchgeführt wird, wobei die Eingangsanschlüsse (3) der Signalverarbeitungseinheit (19) jeweils mit einem optoelektronischen Sensor (4, 5, 16) einer Mutingstation (17) verbunden sind, wobei die optoelektronischen Sensoren (4, 5, 16) jeweils zur Detektion von Objekten (22) an der Mutingstation (17) angeordnet sind und die Verarbeitungseinheit (9) am Ausgangsanschluss (8) der Signalverarbeitungseinheit (19) eine Mutingauswerteeinheit (18) ist, die dazu ausgelegt ist, ein Objektfeststellungssignal zu überbrücken.

2. System nach Anspruch 1, **dadurch gekennzeichnet, dass** die Signaländerung eine Pegeländerung ist.

3. System nach mindestens einem der vorhergehenden Ansprüche, **dadurch gekennzeichnet, dass** die Signaländerung mindestens eine Signaltestlücke ist, wobei die Testlücke eine Länge von 1 ms bis 50 ms, insbesondere 10 ms beträgt.

4. System nach mindestens einem der vorhergehenden Ansprüche, **dadurch gekennzeichnet, dass** die Signaländerung eine Signalmodulation ist.

5. System nach mindestens einem der vorhergehenden Ansprüche, **dadurch gekennzeichnet, dass** mehr als zwei Sensoren (4, 5) angeschlossen sind, wobei die Steuer- und Auswerteeinheit (10) ausgebildet ist, eine Signaländerung bei einem Sensorsignal (M1) eines Sensors (4) zu erzeugen bei einer Flanke oder Signaländerung eines Sensorsignals (M2, M3) eines anderen Sensors (5), wobei die Signaländerung eine vorgegebene Zeitdauer aufrechterhalten ist.

6. Verfahren mit einem System, umfassend eine Signalverarbeitungseinheit (19) zur Erzeugung eines Ausgangssignals an einem Ausgangsanschluss (8) mit einem Kabel (6) mit mindestens zwei Signalleitern (7), wobei ein erstes Sensorsignal (M1) eines ersten Sensors (4) an einem ersten Eingangsanschluss (3) anliegt und ein zweites Sensorsignal (M2) eines zweiten Sensors (5) an einem zweiten Eingangsanschluss (3) anliegt, wobei die Eingangsanschlüsse (3) jeweils mit einem Kabel (6) verbunden sind,
**dadurch gekennzeichnet, dass**
die Signalverarbeitungseinheit (19) eine Steuer- und Auswerteeinheit (10) umfasst, wobei die Steuer- und Auswerteeinheit (10) eine Signaländerung bei einem ersten Sensorsignal (M1) eines ersten Sensors (4) erzeugt bei einer Flanke oder Signaländerung eines zweiten Sensorsignals (M2) eines zweiten Sensors (5), wobei die Signaländerung des ersten Sensorsignals eine vorgegebene Zeitdauer aufrechterhalten wird,
wobei die Steuer- und Auswerteeinheit (10) das erste geänderte Sensorsignal (M1*) und das zweite Sensorsignal (M2*) jeweils auf den Signalleitern (7) des Ausgangsanschlusses (8) ausgibt, wobei eine Querschlusserkennung in einer Verarbeitungseinheit (9) oder in der Signalverarbeitungseinheit (19) ausgangsseitig durchgeführt wird, wobei die Eingangsanschlüsse (3) der Signalsverarbeitungseinheit (19) jeweils mit einem optoelektronischen Sensor (16) einer Mutingstation (17) verbunden werden, wobei die optoelektronischen Sensoren (16) jeweils zur Detektion von Material an einer Mutingstation (17) angeordnet werden und die Verarbeitungseinheit (9) am Ausgangsanschluss (8) der Signalverarbeitungseinheit (19) eine Mutingauswerteeinheit (18) ist, die dazu ausgelegt ist, ein Objektfeststellungssignal zu überbrücken.

7. Verfahren nach Anspruch 6, **dadurch gekennzeichnet, dass** die Signaländerung eine Pegeländerung ist.

8. Verfahren nach mindestens einem der vorhergehenden Ansprüche 6 bis 7,
**dadurch gekennzeichnet, dass** die Signaländerung mindestens eine Signaltestlücke ist, wobei die Testlücke eine Länge von 1 ms bis 50 ms, insbesondere 10 ms beträgt.

9. Verfahren nach mindestens einem der vorhergehenden Ansprüche 6 bis 8,
**dadurch gekennzeichnet, dass** die Signaländerung eine Signalmodulation ist.

10. Verfahren nach mindestens einem der vorhergehenden Ansprüche 6 bis 9,
**dadurch gekennzeichnet, dass** mehr als zwei Sensoren (4, 5) angeschlossen sind, wobei durch die Steuer- und Auswerteeinheit (10) eine Signaländerung bei einem Sensorsignal (M1) eines Sensors (4) erzeugt wird bei einer Flanke oder Signaländerung eines Sensorsignals (M2, M3) eines anderen Sensors (5), wobei die Signaländerung eine vorgegebene Zeitdauer aufrechterhalten ist.

## Claims

1. A system comprising a processing unit (9), two sensors (4, 5, 16), and a signal processing unit (19) having at least two separate input ports (3) for a respective one of the sensors (4, 5, 16), having a respective cable (6) having at least one signal conductor (7) for each sensor (4, 5, 16), and having at least one output port (8) for transmitting the sensor signals (M) to a processing unit (9) by means of a cable (6) having at least two signal conductors (7),
**characterized in that**
the signal processing unit (19) comprises a control and evaluation unit (10), wherein the control and evaluation unit (10) is configured to generate a signal change in a first sensor signal (M1) of the first sensor (4) at a flank or a signal change of a second sensor signal (M2) of the second sensor (5), with the signal change of the first sensor signal being maintained for a predefined time period,
with the control and evaluation unit (10) being configured to output the first changed sensor signal (M1*) and the second sensor signal (M2*) respectively at the signal conductors (7) of the output port (8), with a cross-circuit recognition being carried out at the output side in the processing unit (9) or in the signal processing unit (19), with the input ports (3) of the signal processing unit (19) being respectively connected to an optoelectronic sensor (4, 5, 16) of a muting station (17), with the optoelectronic sensors (4, 5, 16) each being arranged for the detection of objects (22) at the muting station (17), and with the processing unit (9) at the output port (8) of the signal processing unit (19) being a muting evaluation unit (18) that is configured to bridge an object determination signal.

2. A system in accordance with claim 1, **characterized in that** the signal change is a level change.

3. A system in accordance with at least one of the preceding claims, **characterized in that** the signal change is at least one signal test gap, with the test gap amounting to a length of 1 ms to 50 ms, in particular to 10 ms.

4. A system in accordance with at least one of the preceding claims, **characterized in that** the signal change is a signal modulation.

5. A system in accordance with at least one of the preceding claims, **characterized in that** more than two sensors (4, 5) are connected, with the control and evaluation unit (10) being configured to generate a signal change in a sensor signal (M1) of a sensor (4) at a flank or a signal change of a sensor signal (M2, M3) of a different sensor (5), with the signal change being maintained for a predefined time period.

6. A method having a system comprising a signal processing unit (19) for generating an output signal at an output port (8) having a cable (6) having at least two signal conductors (7), wherein a first sensor signal (M1) of a first sensor (4) is applied at a first input port (3) and a second sensor signal (M2) of a second sensor (5) is applied at a second input port (3); and wherein the input ports (3) are each connected by a cable (6), **characterized in that**
the signal processing unit (19) comprises a control and evaluation unit (10), with the control and evaluation unit (10) generating a signal change in a first sensor signal (M1) of a first sensor (4) at a flank or a signal change of a second sensor signal (M2) of a second sensor (5), with the signal change of the first sensor signal being maintained for a predefined time period, with the control and evaluation unit (10) outputting the first changed sensor signal (M1*) and the second sensor signal (M2*) respectively at the signal conductors (7) of the output port (8), with a cross-circuit recognition being carried out at the output side in a processing unit (9) or in the signal processing unit (19), with the input ports (3) of the signal processing unit (19) being respectively connected to an optoelectronic sensor (16) of a muting station (17), with the optoelectronic sensors (16) each being arranged for the detection of material at a muting station (17), and with the processing unit (9) at the output port (8) of the signal processing unit (19) being a muting evaluation unit (18) that is configured to bridge an object determination signal.

7. A method in accordance with claim 6, **characterized in that** the signal change is a level change.

8. A method in accordance with at least one of the claims 6 to 7, **characterized in that** the signal change is at least one signal test gap, with the test gap amounting to a length of 1 ms to 50 ms, in particular to 10 ms.

9. A method in accordance with at least one of the claims 6 to 8, **characterized in that** the signal change is a signal modulation.

10. A method in accordance with at least one of the claims 6 to 9, **characterized in that** more than two sensors (4, 5) are connected, with the control and evaluation unit (10) generating a signal change in a sensor signal (M1) of a sensor (4) at a flank or a signal change of a sensor signal (M2, M3) of a different sensor (5), with the signal change being maintained for a predefined time period.

## Revendications

1. Système comprenant une unité de traitement (9), deux capteurs (4, 5, 16) et une unité de traitement de signaux (19) pourvue d'au moins deux bornes d'entrée séparées (3) respectivement pour l'un des capteurs (4, 5, 16), d'un câble (6) ayant au moins un conducteur de signaux respectif (7) pour chaque capteur (4, 5, 16), et d'au moins une borne de sortie (8) pour transmettre les signaux de capteur (M) à une unité de traitement (9) au moyen d'un câble (6) ayant au moins deux conducteurs de signaux (7),
**caractérisé en ce que**
l'unité de traitement de signaux (19) comprend une unité de commande et d'évaluation (10), l'unité de commande et d'évaluation (10) étant réalisée pour générer une modification de signal dans un premier signal de capteur (M1) du premier capteur (4) lors d'un flanc ou d'une modification de signal du second signal de capteur (M2) du second capteur (5), la modification du premier signal de capteur étant maintenue pendant une durée temporelle prédéterminée,
l'unité de commande et d'évaluation (10) étant réalisée pour émettre le premier signal de capteur (M1*) modifié et le second signal de capteur (M2*) respectivement sur les conducteurs de signaux (7) de la borne de sortie (8), en réalisant du côté sortie une détection de courts-circuits transversales dans l'unité de traitement (9) ou dans l'unité de traitement de signaux (19), les bornes d'entrée (3) de l'unité de traitement de signaux (19) étant reliées chacune à un capteur optoélectronique (4, 5, 16) d'une station d'inhibition (17), les capteurs optoélectroniques (4, 5, 16) étant agencés chacun pour la détection d'objets (22) au niveau de la station d'inhibition (17), et l'unité de traitement (9) à la borne de sortie (8) de l'unité de traitement de signaux (19) étant une unité d'évaluation d'inhibition (18) qui est conçue pour ponter un signal de constatation d'objet.

2. Système selon la revendication 1, **caractérisé en ce que** la modification de signal est une modification de niveau.

3. Système selon l'une au moins des revendications précédentes, **caractérisé en ce que** la modification de signal est au moins une lacune de test de signal, la lacune de test étant d'une longueur de 1 ms à 50 ms, en particulier de 10 ms.

4. Système selon l'une au moins des revendications précédentes, **caractérisé en ce que** la modification de signal est une modulation de signal.

5. Système selon l'une au moins des revendications précédentes, **caractérisé en ce que** plus de deux capteurs (4, 5) sont branchés, l'unité de commande et d'évaluation (10) étant réalisée pour générer une modification de signal dans un signal de capteur (M1) d'un capteur (4) lors d'un flanc ou d'une modification de signal d'un signal de capteur (M2, M3) d'un autre capteur (5), la modification de signal étant maintenue pendant une durée temporelle prédéterminée.

6. Procédé mis en oeuvre avec un système, comprenant une unité de traitement de signaux (9) pour générer un signal de sortie à une borne de sortie (8) pourvue d'un câble (6) ayant au moins deux conducteurs de signaux (7), un premier signal de capteur (M1) d'un premier capteur (4) étant appliqué à une première borne d'entrée (3) et un second signal de capteur (M2) d'un second capteur (5) étant appliqué à une seconde borne d'entrée (3), les bornes d'entrée (3) étant connectées chacune à un câble (6),
**caractérisé en ce que**
l'unité de traitement de signaux (10) comprend une unité de commande et d'évaluation (10), l'unité de commande et d'évaluation (10) générant une modification de signal dans un premier signal de capteur (M1) d'un premier capteur (4) lors d'un flanc ou d'une modification de signal d'un second signal de capteur (M2) d'un second capteur (5), la modification du premier signal de capteur étant maintenue pendant une durée temporelle prédéterminée,
l'unité de commande et d'évaluation (10) émettant le premier signal de capteur (M1*) modifié et le second signal de capteur (M2*) respectivement sur les conducteurs de signaux (7) de la borne de sortie (8), en réalisant du côté sortie une détection de courts-circuits transversales dans une unité de traitement (9) ou dans l'unité de traitement de signaux (19), les bornes d'entrée (3) de l'unité de traitement de signaux (19) étant reliées chacune à un capteur optoélectronique (4, 5, 16) d'une station d'inhibition (17), les capteurs optoélectroniques (16) étant agencés chacun pour la détection d'un matériau au niveau d'une station d'inhibition (17), et l'unité de traitement (9) à la borne de sortie (8) de l'unité de traitement de signaux (19) étant une unité d'évaluation d'inhibition (18) qui est conçue pour ponter un signal de constatation d'objet.

7. Procédé selon la revendication 6, **caractérisé en ce que** la modification de signal est une modification de niveau.

8. Procédé selon l'une au moins des revendications précédentes 6 à 7, **caractérisé en ce que** la modification de signal est au moins une lacune de test de signal, la lacune de test étant d'une longueur de 1 ms à 50 ms, en particulier de 10 ms.

9. Procédé selon l'une au moins des revendications précédentes 6 à 8, **caractérisé en ce que** la modification de signal est une modulation de signal.

10. Procédé selon l'une au moins des revendications précédentes 6 à 9, **caractérisé en ce que** plus de deux capteurs (4, 5) sont branchés, l'unité de commande et d'évaluation (10) générant une modification de signal dans un signal de capteur (M1) d'un capteur (4) lors d'un flanc ou d'une modification de signal d'un signal de capteur (M2, M3) d'un autre capteur (5), la modification de signal étant maintenue pendant une durée temporelle prédéterminée.
